# EUROPEAN PATENT APPLICATION

(11) **EP 2 584 605 A2**
(43) Date of publication of application: **24.04.2013**
(21) Application number: 12189084.2
(22) Date of filing: 18.10.2012
(51) Int. Cl.: H01L 23/552

(54) **Packaging structure and method and electronic device**

(30) Priority: 21.10.2011 CN 201110322652
(71) Applicant: Huawei Device Co., Ltd., Longgang District Shenzhen Guangdong 518129 (CN)
(72) Inventor: Cheng, Yinghua, 518129 Shenzhen (CN); Sun, Rui, 518129 Shenzhen (CN); Wang, Fengping, 518129 shenzhen (CN); Ding, Haixing, 518129 Shenzhen (CN)
(74) Representative: Epping - Hermann - Fischer

(57) **Abstract**

Embodiments of the present invention disclose a packaging structure and method and an electronic device. The packaging structure includes: a substrate (21), where the substrate (21) is arranged with a grounding end (27) and at least two circuit modules; a shielding separator (24) connected to the substrate (21) for separating the at least two circuit modules; a packaging insulator (25) applied on the substrate (21) for covering the at least two circuit modules, where the packaging insulator (25) is lower than the shielding separator (24); and a conductive coating (26) connected to the grounding end (27) and applied on the packaging insulator (25) for covering the packaging insulator (25) and the shielding separator (24). By using embodiments of the present invention, multiple shielded areas may be formed inside a packaging structure, which reduces electromagnetic interference between modules inside the packaging structure, and meanwhile, improves functional performance of circuits inside the packaging structure.

## Description

### FIELD OF THE INVENTION

Embodiments of the present invention relate to electronic technologies, and in particular, to a packaging structure and method and an electronic device.

### BACKGROUND OF THE INVENTION

Electromagnetic interference is a serious problem for most electronic devices and circuit systems because the electromagnetic interference often breaks, blocks, or reduces performance of the electronic devices or circuit systems. Therefore, the electromagnetic interference needs to be effectively shielded to ensure the efficiency and safe operation of the electronic devices or circuit systems.

Conventional packaging technologies mostly use film technologies or fine-pitch connection technologies. For example, in a semiconductor packaging structure, a semiconductor chip is connected to a conductor part in a substrate to lead out a wiring pin, and is fixed by filling in a plastic insulating medium; then, a conductive coating is used to cover a packaging body (that is, cover the plastic insulating medium and an uncovered surface of the substrate around the plastic insulating medium) and grounding is implemented by connecting the conductive coating to an exposed "ground" of the packaging body, thereby forming a packaging structure. The packaging structure has, in addition to shielding effect, functions such as circuit connecting, physical supporting, and protecting.

However, the packaging structure and packaging method in prior art has at least the following problem: The conventional packaging structure and packaging method are capable of forming only one fully covered shielding, which limits functional performance of circuits inside the packaging body.

### SUMMARY OF THE INVENTION

Embodiments of the present invention provide a packaging structure and method and an electronic device for solving the technical problem of the conventional packaging structure and packaging method in which only one fully covered shielding is formed and functional performance of circuits inside a packaging body is limited.

In one aspect, an embodiment of the present invention provides a packaging structure, including:
a substrate 21, where the substrate 21 is arranged with a grounding end 27 and at least two circuit modules;
a shielding separator 24 connected to the substrate 21 for separating the at least two circuit modules;
a packaging insulator 25 applied on the substrate 21 for covering the at least two circuit modules, where the packaging insulator 25 is lower than the shielding separator 24; and
a conductive coating 26 connected to the grounding end 27 and applied on the packaging insulator 25 for covering the packaging insulator 25 and the shielding separator 24.

In another aspect, an embodiment of the present invention further provides a packaging method, including:
connecting a shielding separator to a substrate which is arranged with a grounding end and at least two circuit modules to separate the at least two circuit modules;
applying a packaging insulator on the substrate to cover the at least two circuit modules, wherein the packaging insulator is lower than the shielding separator; and
applying a conductive coating on the packaging insulator to cover the packaging insulator and the shielding separator and connecting the conductive coating to a grounding end of the substrate.

In another aspect, an embodiment of the present invention further provides an electronic device which includes the above packaging structure.

By using the technical means of connecting a shielding separator to a substrate to separate at least two circuit modules, applying a packaging insulator and a conductive coating, and grounding the shielding separator by using the conductive coating, multiple separated shielding parts are formed inside a packaging structure, thereby forming multiple shielded areas, reducing electromagnetic interference between circuit modules inside the packaging structure, and meanwhile, improving functional performance of the circuit inside the packaging structure.

### BRIEF DESCRIPTION OF THE DRAWINGS

To illustrate the technical solutions according to the embodiments of the present invention or in the prior art more clearly, accompanying drawings required for describing the embodiments or the prior art are introduced briefly below. Apparently, the accompanying drawings in the following description are merely some embodiments of the present invention, and persons of ordinary skill in the art may further obtain other drawings according to the accompanying drawings without creative efforts.
FIG. 1 is a schematic sectional front view of a semiconductor circuit packaging structure according to the prior art;
FIG. 2a is a schematic sectional top view of a packaging structure according to a first embodiment of the present invention;
FIG. 2b is a schematic sectional front view of a packaging structure according to the first embodiment of the present invention;
FIG. 3a is a schematic sectional top view of a packaging structure according to a second embodiment of the present invention;
FIG. 3b is a schematic sectional front view of a packaging structure according to the second embodiment of the present invention;
FIG. 3c is a schematic sectional side view of a packaging structure according to the second embodiment of the present invention; and
FIG. 4 is a schematic flowchart of a packaging method according to a third embodiment of the present invention.

### DETAILED DESCRIPTION OF THE EMBODIMENTS

In order to make the objectives, technical solutions, and advantages of the present invention more comprehensible, the technical solutions according to the embodiments of the present invention are clearly and completely described in the following with reference to the accompanying drawings. Apparently, the embodiments in the following description are merely a part rather than all of the embodiments of the present invention. All other embodiments obtained by persons of ordinary skill in the art based on the embodiments of the present invention without creative efforts shall fall within the protection scope of the present invention.

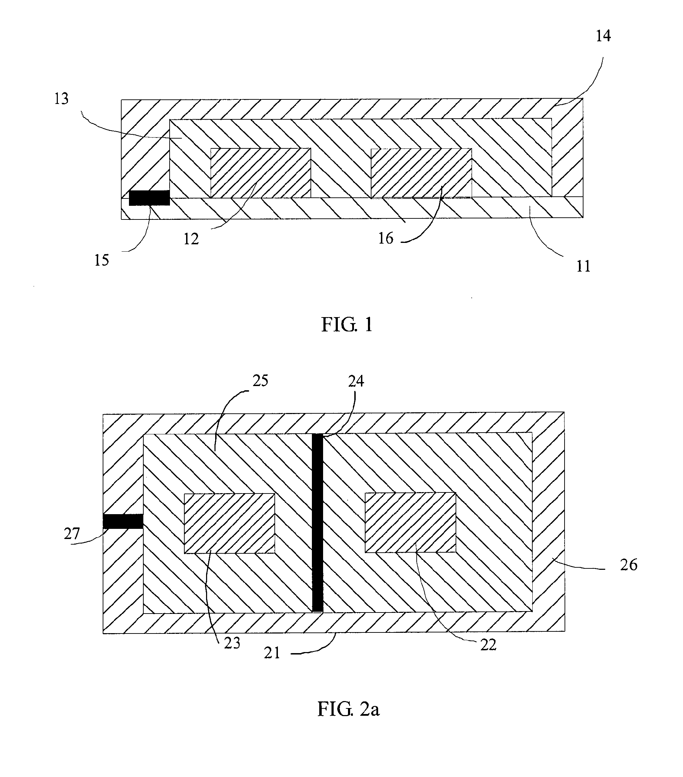

FIG. 1 is a schematic sectional front view of a semiconductor circuit packaging structure according to the prior art. As shown in FIG. 1, the packaging structure includes:
a substrate 11, where the substrate 11 is arranged with a ground end 15, a semiconductor circuit 12, and a semiconductor circuit 16;
a packaging insulator 13 applied on the substrate 11 for covering the semiconductor circuit 12 and the semiconductor circuit 16; and
a conductive coating 14 applied on the packaging insulator 13 and the substrate 11 for covering the packaging insulator 13 and an uncovered surface of the substrate 11 around the packaging insulator 13, where the conductive coating 14 is connected to the grounding end 15 of the substrate 11, to form an electromagnetic-shielded grounding circuit of the semiconductor circuit packaging structure. Specifically, the grounding end 15 is located on an uncovered side of the substrate 11 outside the packaging insulator 13 and is covered by the conductive coating 14.

According to the above description, a packaging structure in the prior art is capable of forming only one fully covered shielding. That is, the packaging structure in the prior art is capable of shielding circuits inside the packaging structure from outside electromagnetic interference; however, because the packaging structure in the prior art is capable of forming only one fully covered shielding, but not capable of forming several shielded areas, if there are several circuit modules inside the packaging structure, electromagnetic interference is likely to occur between the circuit modules, which affects functional performance of several circuit modules inside the packaging structure.

### Embodiment 1

To solve the problem of the prior art, by connecting (preferably, by welding) a shielding separator to a substrate to separate at least two circuit modules, applying a packaging insulator and a conductive coating, and grounding the shielding separator by using the conductive coating, an embodiment of the present invention is capable of forming multiple isolated shielding parts inside a packaging structure, thereby forming multiple shielded areas, and reducing electromagnetic interference between circuit modules inside the packaging structure.

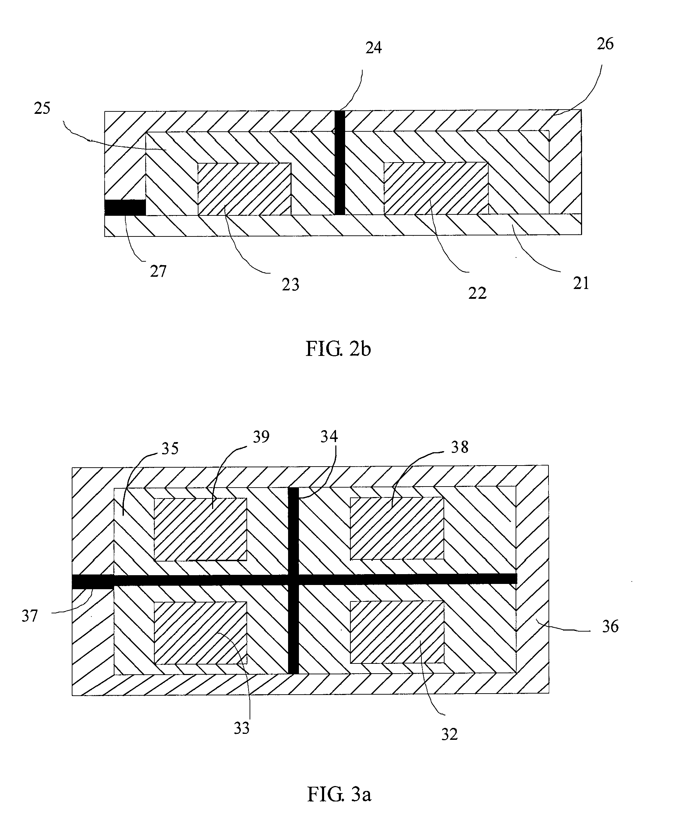

FIG. 2a is a schematic sectional top view of a packaging structure according to a first embodiment of the present invention, and FIG. 2b is a schematic sectional front view of the packaging structure according to the first embodiment of the present invention. As shown in FIG. 2a and FIG. 2b, the packaging structure includes:
a substrate 21, where the substrate 21 is arranged with a grounding end 27 and at least two circuit modules, namely, a circuit module 22 and a circuit module 23;
a shielding separator 24 connected to the substrate 21 for separating the at least two circuit modules;
a packaging insulator 25 applied on the substrate 21 for covering the at least two circuit modules, where the packaging insulator 25 is lower than the shielding separator 24 in height; and
a conductive coating 26 connected to the grounding end 27 of the substrate 21 and applied on the packaging insulator 25 for covering the packaging insulator 25 and the shielding separator 24.

The substrate 21 may be a resin substrate, a glass substrate, a semiconductor substrate, or a metal substrate. The circuit modules may be semiconductor circuits, modular circuits, system in package modules (SIP module), wafer circuits, or chip circuits.

Specially, the arranging the at least two circuit modules on the substrate 21 is specifically: fixing the circuit module 22 and the circuit module 23 on a top surface of the substrate 21 by using an adhesive agent having a fixing function, implementing a wire bonding connection process or a flip chip connection process, and electrically connecting solder pads on surfaces of the circuit module 22 and the circuit module 23 to corresponding solder pads on the surface of the substrate 21 respectively by using a wire or a solder ball. The arranging the grounding end 27 on the substrate 21 is specifically: electrically connecting the grounding end 27 to a ground point through a circuit inside the substrate 21.

The shielding separator 24 may be a metal separator, a silicon rubber separator, or the like, for separating the circuit module 22 and the circuit module 23. In the embodiment, the shielding separator 24 is preferably soldered on the substrate 21 and the shielding separator 24 is grounded through the conductive coating 26, so that the positive charge outside the shielding separator 24 flows to ground and the shielding is implemented.

The packaging insulator 25 may be epoxy resin, silicon resin, or the like, for protecting the circuit modules from being damaged or corroded by external forces, moisture, or other substances.

The conductive coating 26 may be an adhesive agent containing metal conducting particles and epoxy resin or polyurethane, and is applied on the surface of the packaging insulator 25 by means such as coating, spraying, or printing, for covering the packaging insulator 25 and the shielding separator 24. In this embodiment, the conductive coating 26 may be directly applied on the grounding end 27 of the substrate 21, or electrically connected to the grounding end 27 by using a bonding wire, so that the conductive coating 26 is electrically connected to a ground point with zero potential, for forming an electromagnetic-shielded grounding circuit of the packaging structure.

According to a packaging structure of this embodiment, by using the technical means of connecting a shielding separator to a substrate to separate at least two circuit modules, applying a packaging insulator and a conductive coating, and grounding the shielding separator by using the conductive coating, multiple shielded areas are formed inside the packaging structure, electromagnetic interference between circuit modules inside the packaging structure is reduced, and functional performance of circuits inside the packaging structure is improved.

### Embodiment 2

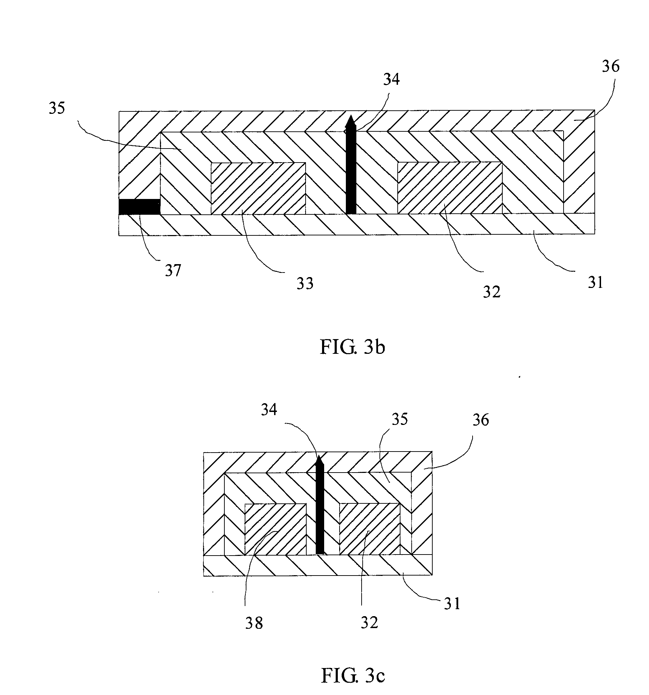

FIG. 3a is a schematic sectional top view of a packaging structure according to a second embodiment of the present invention; FIG. 3b is a schematic sectional front view of the packaging structure according to the second embodiment of the present invention; and FIG. 3c is a schematic sectional side view of the packaging structure according to the second embodiment of the present invention. The second embodiment is formed by extending the first embodiment by using semiconductor circuits as an example based on the first embodiment shown in FIGS. 2a and 2b. Specifically, a shielding separator of the embodiment of the present invention is preferably a metal separator having advantages of low resistance and good conductivity. A top surface of the metal separator includes multiple protrusion parts which are preferably sawteeth but not limited to the sawteeth. A longitudinal section of the sawtooth specifically includes a triangle or a circle arc, but is not limited to the triangle or the circle arc. As shown in FIG. 3a, FIG. 3b, and FIG. 3c, a packaging structure of the embodiment includes:
a substrate 31, where a grounding end 37 is disposed on a surface of the substrate 31, and a semiconductor circuit 32, a semiconductor circuit 33, a semiconductor circuit 38, and a semiconductor circuit 39 are arranged on the substrate 31; the grounding end 37 of the substrate 31 of the embodiment may be electrically connected to a ground point through a circuit inside the substrate 31; for example, the substrate 31 of the embodiment is a semiconductor substrate, the semiconductor circuit 32 is a readable memory, the semiconductor circuit 33 is an analog circuit, the semiconductor circuit 38 is an amplifier, and the semiconductor circuit 39 is an oscillator; the semiconductor circuits in the embodiment of the present invention are not limited to the specific examples, and the semiconductor circuits depend on specific circuits requirements; in the embodiment, an adhesive agent having a fixing function is used to fix the semiconductor circuit 32 on a top surface of the substrate 31, then a wire bonding connection process or a flip chip connection process is implemented, and a wire or a solder ball is used to electrically connect solder pads on a surface of the semiconductor circuit 32 to corresponding solder pads on the surface of the substrate 31; the semiconductor circuit 33, the semiconductor circuit 38, and the semiconductor circuit 39 are electrically connected to the substrate 31 in a similar manner;
a metal separator 34 is connected, preferably soldered on the substrate 31, where a top surface of the metal separator 34 includes multiple protrusion parts, the protrusion parts are preferably sawteeth, and the metal separator 34 is in a cross form, to separate the semiconductor circuit 32, the semiconductor circuit 33, the semiconductor circuit 38, and the semiconductor circuit 39; in the embodiment, the metal separator 34 is not limited to a cross form, and any form which is capable of separating circuit modules inside the packaging structure shall fall within the protection scope of the embodiment of the present invention;
a packaging insulator 35 applied on the substrate 31 for covering the semiconductor circuit 32, the semiconductor circuit 33, the semiconductor circuit 38, and the semiconductor circuit 39; and
a conductive coating 36 applied on the packaging insulator 35 for covering the metal separator 34, a top surface and side walls of the packaging insulator 35, and the surface of the substrate 31 around the packaging insulator 35. In the embodiment, the conductive coating 36 is connected to the sawteeth of the metal separator 34, so that the metal separator 34 is connected to the conductive coating 36. In the embodiment, the conductive coating 36 may directly cover the grounding end 37 of the substrate 31, or electrically connected to the grounding end 37 by using a bonding wire, so that the conductive coating 36 is electrically connected to a ground point with zero potential, thereby forming an electromagnetic-shielded grounding circuit of a semiconductor circuit packaging structure.

In the embodiment, a metal separator is soldered on a substrate spaced between semiconductor circuits to separate the semiconductor circuits, and the metal separator is connected to a conductive coating by using sawteeth of the metal separator so as to be grounded, so that multiple isolated shielding parts are formed between the semiconductor circuits, and finally multiple isolated shielding parts are formed inside a semiconductor circuit packaging structure, thereby effectively reducing electromagnetic radiation interference between circuit modules inside a semiconductor circuit, and improving functional performance of circuits inside the packaging structure. In addition, in the embodiment, by using sawteeth on a top surface of the metal separator, a process for fabricating a packaging structure is simplified, thereby reducing the cost of fabricating the packaging structure.

Circuit modules in the second embodiment of the present invention are described by using semiconductor circuits as an example; however, according to the second embodiment of the present invention and common sense, persons skilled in the art may easily replace the circuit modules with a chip circuit, a wafer circuit, or a SIP module to obtain a chip circuit packaging structure, a wafer circuit packaging structure, or a SIP module packaging structure.

### Embodiment 3

In the embodiment, by connecting a shielding separator to a substrate to separate at least two circuit modules, applying a packaging insulator and a conductive coating, and grounding the shielding separator by using the conductive coating, multiple shielded areas may be formed inside a packaging structure, thereby reducing electromagnetic interference between circuit modules inside the packaging structure.

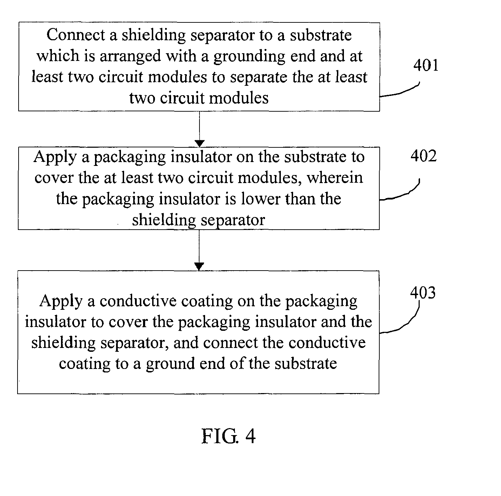

FIG. 4 is a schematic flowchart of a packaging method according to a third embodiment of the present invention. As shown in FIG. 4, the method includes:
Step 401: connecting a shielding separator to a substrate which is arranged with a grounding end and at least two circuit modules to separate the at least two circuit modules;
Step 402: applying a packaging insulator on the substrate for covering the at least two circuit modules, where the packaging insulator is lower than the shielding separator; and
Step 403: applying a conductive coating on the packaging insulator to cover the packaging insulator and the shielding separator and connecting the conductive coating to a grounding end of the substrate.

The packaging method provided by the third embodiment of the present invention is capable of implementing the packaging structure provided by the first embodiment of the present invention, and the implementation principle and technical effects of the packaging structure will not be described repeatedly herein.

When the shielding separator is preferably a metal separator and a top surface of the metal separator includes multiple sawteeth, the packaging method of the embodiment further includes: soldering the metal separator on the substrate to separate the circuit modules on the substrate; designing the top surface of the metal separator in a sawteeth form; during the packaging of an insulator, after the metal separator is covered by the insulator, slightly reducing thickness of the insulator from the top surface in a subsequent sandblasting process, as long as the sawteeth of the metal separator appear; and then coating the conductive coating, where the metal separator and the conductive coating are grounded through the sawteeth, thereby forming multiple isolated shielding parts inside the packaging structure.

In the embodiment, the top surface of the metal separator is designed to be in the sawteeth form. Therefore, after the metal separator is covered by the packaging insulator, the thickness of the packaging insulator may be easily reduced from the top surface in a subsequent sandblasting process, so that the top surface of sawteeth of the metal separator can appear, thereby simplifying a process of a conventional packaging method and reducing a fabrication cost.

At least one packaging structure of embodiments of the present invention may be applied to multiple electronic devices, such as an electronic chip, a semiconductor integrated circuit, and a data card. Persons skilled in the art may understand that the packaging structure in the embodiments of the present invention may be used to avoid interference in any scenario in which there are at least two circuit modules.

Finally, it should be noted that the foregoing embodiments are merely provided for describing the technical solutions of the present invention, but not intended to limit the present invention. It should be understood by persons skilled in the art that although the present invention is described in detail with reference to the embodiments, modifications may be made to the technical solutions described in each of the embodiments, or equivalent replacements may be made to some technical features in the technical solutions, as long as such modifications or replacements do not cause the essence of corresponding technical solutions to depart from the idea and scope of the technical solutions in each of the embodiments of the present invention.

## Claims

1. A packaging structure, comprising:
a substrate (21), wherein the substrate (21) is arranged with a grounding end (27) and at least two circuit modules;
a shielding separator (24) connected to the substrate (21) for separating the at least two circuit modules;
a packaging insulator (25) applied on the substrate (21) for covering the at least two circuit modules, wherein the packaging insulator (25) is lower than the shielding separator (24); and
a conductive coating (26) connected to the grounding end (27) and applied on the packaging insulator (25) for covering the packaging insulator (25) and the shielding separator (24).

2. The packaging structure according to claim 1, wherein the shielding separator (24) comprises multiple protrusion parts on a top surface.

3. The packaging structure according to claim 2, wherein the protrusion parts are sawteeth.

4. The packaging structure according to claim 3, where a longitudinal section of the sawtooth is a triangle or a circle arc.

5. The packaging structure according to any one of claims 1 to 4, wherein the conductive coating (26) is applied on the grounding end (27).

6. The packaging structure according to any one of claims 1 to 4, wherein the conductive coating (26) is electrically connected to the grounding end (27) by using a bonding wire.

7. The packaging structure according to any one of claims 1 to 6, wherein the at least two circuit modules comprise a chip circuit, a wafer circuit, or a semiconductor circuit.

8. A packaging method, comprising:
connecting a shielding separator to a substrate which is arranged with a grounding end and at least two circuit modules to separate the at least two circuit modules;
applying a packaging insulator on the substrate to cover the at least two circuit modules, wherein the packaging insulator is lower than the shielding separator; and
applying a conductive coating on the packaging insulator to cover the packaging insulator and the shielding separator and connecting the conductive coating to a grounding end of the substrate.

9. The method according to claim 8, wherein the connecting the conductive coating to the grounding end of the substrate specifically comprises: applying the conductive coating on the grounding end.

10. The method according to claim 8, wherein the connecting the conductive coating to the grounding end of the substrate specifically comprises: electrically connecting the conductive coating to the grounding end by using a bonding wire.

11. An electronic device, comprising the packaging structure according to any one of claims 1 to 7.

12. The electronic device according to claim 11, wherein the electronic device comprises a data card.
